# EUROPEAN PATENT APPLICATION

(11) **EP 4 723 496 A1**
(43) Date of publication of application: **08.04.2026**
(21) Application number: 24306628.9
(22) Date of filing: 04.10.2024
(51) Int. Cl.: H04B 5/26, H04B 5/43

(54) **AN ANTENNA ARRANGEMENT**

(71) Applicant: NXP B.V., 5656 AG Eindhoven (NL)
(72) Inventor: MERLIN,, Erich, 5656 AG Eindhoven (NL); KURVATHODIL,, Manoj, 5656 AG Eindhoven (NL); MAURICE,, Eric, 31023 Toulouse (FR); MOREAU,, Olivier Claude, 31023 Toulouse (FR)
(74) Representative: Krott, Michel

(57) **Abstract**

An antenna arrangement comprising: a first antenna; a second antenna; a first transmitter path extending from a first end to a second end wherein the first antenna is arranged at the second end of the first transmitter path; a second transmitter path extending from a first end to a second end wherein the second antenna is arranged at the second end of the second transmitter path; a matching circuit comprising a first capacitor along the first transmitter path, a second capacitor arranged along the second transmitter path; a first receiver path coupled to the first transmitter path at a first tapping point; and a second receiver path coupled to the second transmitter path at a second tapping point; and wherein the antenna arrangement is absent an intermediate reference voltage node between the first antenna and the second antenna.

## Description

### Field

The present disclosure relates to an antenna arrangement and an NFC device. In particular, the present disclosure relates to an antenna arrangement comprising first and second antennas each configured to receive and transmit near field communication signals and an NFC device comprising such an antenna arrangement.

### Summary

According to a first aspect of the present disclosure, there is provided an antenna arrangement comprising: a first antenna configured to receive and transmit a first set of near field communication signals; a second antenna configured to receive and transmit a second set of near field communication signals wherein the first antenna is coupled in series with the second antenna; a first transmitter path extending from a first end to a second end wherein the first antenna is arranged at the second end of the first transmitter path; a second transmitter path extending from a first end to a second end wherein the second antenna is arranged at the second end of the second transmitter path; a matching circuit comprising a first capacitor arranged in series between the first end of the first transmitter path and the first antenna, a second capacitor arranged in series between the first end of the second transmitter path and the second antenna; a first receiver path coupled to the first transmitter path at a first tapping point wherein the first tapping point is between the first end of the first transmitter path and the first antenna; and a second receiver path coupled to the second transmitter path at a second tapping point wherein the second tapping point is between the first end of the second transmitter path and the second antenna; and wherein the antenna arrangement is absent an intermediate reference voltage node between the first antenna and the second antenna.

In one or more embodiments, the matching circuit may further comprise a third capacitor coupled between the first capacitor and the second capacitor.

In one or more embodiments, the antenna arrangement may comprise: a first EMC filter arranged between the first end of the first transmitter path and the first capacitor of the matching circuit; and a second EMC filter arranged between the first end of the second transmitter path and the second capacitor of the matching circuit.

In one or more embodiments, the first tapping point may be arranged between the first EMC filter and the first capacitor of the matching circuit and the second tapping point is arranged between the second EMC filter and the second capacitor of the matching circuit.

In one or more embodiments, each EMC filter may be coupled to a reference voltage node.

In one or more embodiments, the first antenna and the second antenna may be coupled to a reference voltage node via one or both of the first EMC filter and the second EMC filter.

In one or more embodiments, the first EMC filter may comprise a capacitor having a first terminal coupled to the first tapping point, the second EMC filter comprises a capacitor arranged in series with the capacitor of the first EMC filter wherein the capacitor of the second EMC filter comprises a first terminal coupled to the second tapping point, and wherein the antenna arrangement further comprises a reference node configured to provide a reference voltage coupled between the capacitors of the first and second EMC filters.

According to a second aspect of the present disclosure, there is provided a Near Field Communications, NFC, device comprising the antenna arrangement of any preceding claim.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an antenna arrangement of the present disclosure; and
Figure 2 shows an example embodiment of a near field communications device comprising the antenna arrangement.

### Detailed Description

The present disclosure relates to an antenna arrangement for a Near-Field Communications device (NFC device). NFC is a short-range wireless technology that allows NFC-enabled devices to communicate with each other. Such devices may include mobile phones, tablets, laptops, wearables and other devices. NFC technology can be used for contactless payments, data sharing, mobile ticketing and access control, among other uses.

Given the wide range of applications that NFC is being put to in modern society, it is becoming increasingly desirable for an NFC-enabled device to be able to perform multiple functionalities sequentially or simultaneously. Practically, this requires the implementation of multiple antennas which are each configured to receive and transmit NFC signals. The topologies of the present disclosure may provide for improved phase and amplitude balance management.

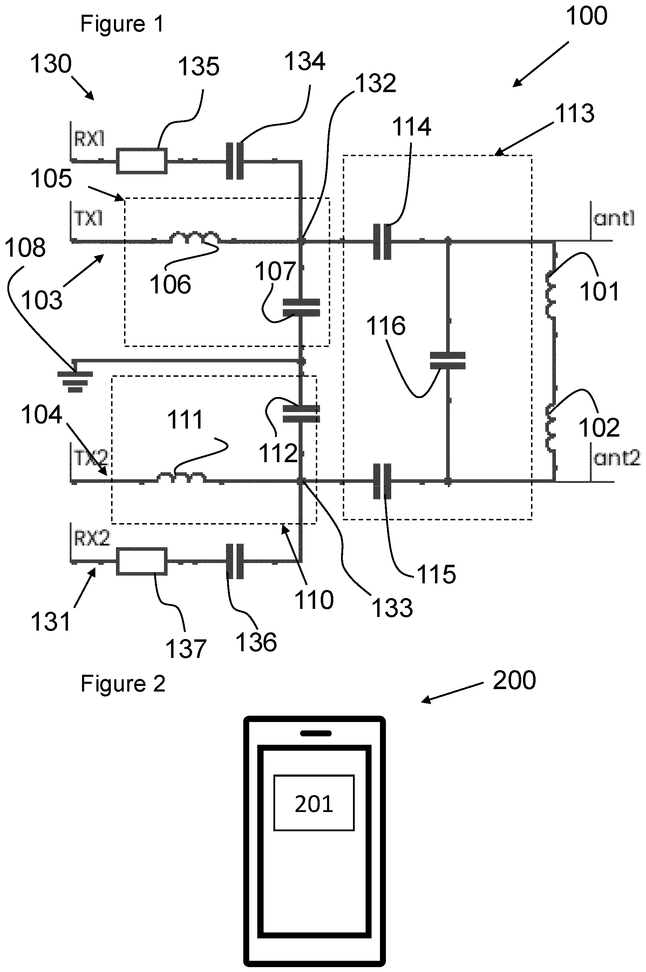

Figure 1 shows an example antenna arrangement 100 according to the present disclosure. The antenna arrangement 100 comprises first and second antennas 101, 102 and the supporting electronics that support the receipt and transmission of near field communication (NFC) signals.

The antenna arrangement 100 comprises a first antenna 101 which is configured to receive and transmit a first set of near field communication signals. The first antenna 101 is represented in figure 1 by inductor 101. The configuration of the first antenna 101 to receive and transmit the near field communication signals includes properties such as its size, conductivity and other electrical or physical properties which allow it to operate as an antenna at a desired frequency or frequencies. For example, a typical operating frequency for NFC may be approximately 13.56 MHz, however, this is not the only frequency which may be selected.

The antenna arrangement 100 further comprises a second antenna 102 which is configured to receive and transmit a second set of near field communication signals. The second antenna 102 is represented in figure 1 by inductor 102. The configuration of the second antenna 102 to provide for the receipt and transmission of NFC signals may include the configuration of the size, conductivity and other electrical or physical properties which allow it to operate as an antenna at a desired frequency or frequencies.

The antenna arrangement 100 further comprises a first transmitter path 103 and a second transmitter path 104. The transmitter paths 103, 104 comprise electronics which may couple their respective antenna 101, 102 to a transmitter device (not shown) where the transmitter device is configured to generate signals for transmission or may be configured to be coupled to a transmitter device configured to generate signals for transmission. That is, it will be appreciated that the antenna arrangement does not necessarily need to be coupled to a transmitter device (or, as will be discussed later, a receiver device) in order to provide all of the features that are core to the present disclosure, as defined in the claims. As a result of this, neither the transmitter device nor the receiver device which could provide for the transmission of signals, or which may process the received signals, respectively, will not be discussed in detail herein. In general, the transmitter device and receiver device may be implemented as an NFC integrated circuit which is configured to generate outgoing signals and process incoming signals. It will be appreciated that alternative implementations may also be used.

The first transmitter path 103 may comprise a first EMC filter 105. The first EMC filter 105 may provide for attenuation of undesirable electromagnetic interference, such as harmonics of the signal for transmission. That is, the first EMC filter 105 may improve the robustness of the antenna arrangement 100 to internally generated or external electromagnetic signals at frequencies which the first EMC filter 105 is configured to attenuate. The first EMC filter 105 may, therefore, allow the antenna arrangement 100 to operate reliably. In other embodiments, the first transmitter path may not comprise an EMC filter.

The first EMC filter may comprise a first EMC filter inductor 106 arranged in series between a first end of the first transmitter path 103, where the first end of the first transmitter path 103 may be configured to receive a transmission signal for transmission by the first antenna 101 and the second antenna 102. That is, a first node of the first EMC filter inductor 106 may be coupled to a first node (first end) of the first transmitter path. A second node of the first EMC filter inductor 106 may be coupled to a first node of a shared matching circuit 113, described below. The second node of the first EMC filter inductor 106 may further be coupled to a first node of a first EMC filter capacitor 107. The first EMC filter capacitor 107 may be coupled to a reference voltage node 108, such as a ground node. More specifically, a second node of the first EMC filter capacitor 107 may be coupled to a reference voltage node 108, such as a ground node.

The second EMC filter 110 may comprise a second EMC filter inductor 111 arranged in series between a first end of the second transmitter path 104, where the first end of the second transmitter path 104 may be configured to receive a transmission signal for transmission by the first antenna 101 and the second antenna 102, and an output of the second EMC filter 110. That is, a first node of the second EMC filter inductor 111 may be coupled to a first node of the second transmitter path 104. A second node of the second EMC filter inductor 111 may be coupled to a first node of a shared matching circuit 113, described below. The second node of the second EMC filter inductor 111 may further be coupled to a first node of a second EMC filter capacitor 112. The second EMC filter capacitor 112 may be coupled to a reference voltage node 108, such as a ground node, which may be the reference voltage node to which the first EMC filter capacitor 107 is coupled. More specifically, a second node of the second EMC filter capacitor 112 may be coupled to a reference voltage node 108, such as a ground node. That is, the first and second EMC filter capacitors 107, 112 may be arranged in series between the first transmitter path 103 and the second transmitter path 104 and the first and second EMC filter capacitors 107, 112 may further comprise an intermediate reference voltage node 108 therebetween. In other embodiments, the second transmitter path 104 may not comprise a second EMC filter.

Any reference voltage node referred to herein may comprise a ground node set to a relative 0 volts or may refer to a node which is configured, in use, to be coupled to a ground node set to a relative 0 volts. This reference voltage nodes referred to herein may be reference voltage nodes which are couplable to ground. Any reference node may be set to a same relative voltage as one or more of the other reference nodes, or one or more reference nodes may be set to different reference voltages, as is appropriate to enable operation of the antenna arrangement in the described manner. It will further be appreciated that, typically, reference nodes, such as a ground node, are only considered coupled to ground when the arrangement is coupled to a power source. As such, references to nodes or terminals being couplable to ground are understood by the skilled person as being a clear reference that such an amplifier circuit does not need to be coupled to a power source to be an amplifier circuit according to the present disclosure but is configured to be so coupled in use.

The antenna arrangement 100 may further comprise a matching circuit 113 arranged with components along both the first and second transmitter paths 103, 104. In particular, the matching circuit 113 comprises a first capacitor 114 arranged in series between the first EMC filter 105 and the first antenna 101. The matching circuit 113 further comprises a second capacitor 115 arranged in series between the second EMC filter 110 and the second antenna 102. Finally, the matching circuit 113 comprises a third capacitor 116 coupled between the first capacitor 114 and the second capacitor 115. That is, the third capacitor 116 may be arranged to bridge the first transmitter path 103 and the second transmitter path 104 and is arranged in parallel with the serially connected first antenna 101 and second antenna 102. In one or more embodiments, a first node of the third capacitor 116 may be coupled between a second node of the first capacitor 114 and a first node of the first antenna 101. Further, the second node of the third capacitor 116 may be coupled between a second node of the second capacitor 115 and a first node of the second antenna 102. The matching circuit 113 may be absent a direct connection or coupling to a reference voltage node, such as a ground node. That is, in one or more embodiments, the matching circuit 113 may only be grounded via one or both of the first EMC filter circuit 105 and the second EMC filter circuit 110. In one or more alternative embodiments, the third capacitor 116 may be implemented as a serial capacitor divider comprising a first and second capacitor arranged in series to bridge the first and second transmitter paths 103, 104. In such an embodiment, a reference voltage node, such as a ground node, may be coupled between the first capacitor and the second capacitor of the third serial capacitor divider. Each of the first and second capacitors of a third serial capacitor divider may have the same capacitances as each other in order to provide for the necessary balancing between the first and second transmitter paths 103, 104. In one or more embodiments, the first capacitor 114 and the second capacitor 115 may be implemented as first and second serial capacitor dividers, respectively. When the first capacitor 114 is split into two parts as a serial capacitor divider, the two capacitances may be the same or they may be different. Similarly, when the second capacitor 115 is split into two parts as a serial capacitor divider, the capacitances of the two capacitors may be the same or they may be different..

The first antenna 101 may be coupled to an output node of the matching circuit 113. In particular, a first node of the first antenna 101 may be coupled to an output node of the matching circuit 113 (such as the second node of the first capacitor 114) and a second node of the first antenna 101 may be coupled to a second node of the second antenna 102 such that the two are arranged in series. Similarly, the second antenna 102 may be coupled to an output node of the matching circuit 113 (such as the second node of the second capacitor 115). In particular, a first node of the second antenna 102 may be coupled to an output node of the matching circuit 113 and a second node of the second antenna 102 may be coupled to the second node of the first antenna 101, as described above. The first and second antennas 101, 102 may be arranged in series between the first transmitter path 103 and the second transmitter path 104. In one or more embodiments, the first and second antennas 101, 102 may be absent an intermediate reference voltage node, such as an intermediate ground node. That is, in use, the first and second antennas 101, 102 may be grounded, or may be configured to be grounded, via one or both of the first EMC filter 105 and the second EMC filter 110.

The antenna arrangement 100 further comprises first and second receiver paths 130, 131 which are coupled to their respective transmitter paths 103, 104 at a first tapping point 132 and a second tapping point 133, respectively. While the whole length of conductor between TX1 and the first antenna is referred to herein as the first transmitter path 103, it will be appreciated that this is done for ease of reference. It will be understood that received signals will still travel at least the part of the "first transmitter path 103" (as referred to herein) between the first antenna and the first tapping point 132. Indeed, the received signals may also travel through other parts of the antenna arrangement 100, however, the signals of interest for the receiver path 130 are those which will travel from the first antenna 101 to the first tapping point 132 and from the first tapping point 132 to the first end of the receiver path 130 which may be coupled or couplable to a receiver device. The same description may be equally applied to the path travelled by signals received at the second antenna 102 which travel along at least part of the second transmitter path 104.

The first receiver path 130 may comprise a first receiver path capacitor 134 and a first receiver path resistor 135 wherein the first receiver path capacitor 134 and the first receiver path resistor 135 are coupled in series between a first end (first node) of the first receiver path 130 and the first tapping point 132. The first tapping point 132 may be arranged between the first EMC filter 105 and the first capacitor 114 of the matching circuit 113. Similarly, the second tapping point 133 may be arranged between the second EMC filter 110 and the second capacitor 115 of the matching circuit 113. In other embodiments, the tapping points may not be arranged at the output of their respective EMC filters and, instead, they may be located at a different point along the transmitter path between the first end of their respective transmitter path and their respective antenna. For example, the tapping point may be located at any node of the matching circuit, such as at a node between a capacitor divider of the respective matching circuit. In embodiments wherein the first capacitor 114 of the matching circuit 113 comprises a serial capacitor divider itself comprising a first and second capacitor arranged in series, the first tapping point 132 may be located between the first and second capacitors of the serial capacitor divider. Similarly, in embodiments wherein the second capacitor 115 of the matching circuit 113 comprises a serial capacitor divider itself comprising a first and second capacitor arranged in series, the second tapping point 133 may be located between the first and second capacitors of the second serial capacitor divider.

The topologies described herein may provide for the maintenance of a phase difference of approximately 180° between a first receiver path and a second receiver path. Due to the absence of a reference voltage node (such as a ground node) between the antennas, the signal amplitude and phase are balanced. In embodiments wherein the first and second capacitors 114, 115 of the matching circuit 113 comprise serial capacitor dividers with the tapping points 132, 133 arranged between the capacitors of the serial capacitor dividers, the arrangement of the tapping points may provide for a balancing effect which allows the signal amplitude to have less variation with and without detuning due to the presence of a card near an antenna.

Figure 2 shows an example Near Field Communication (NFC) device 200 comprising the antenna arrangement 201, such as the antenna arrangement 100 of figure 1. The NFC device 200 may be any device in which it may be desirable to have two antennas. For example, the NFC device 200 may be a mobile phone, a tablet device, a smart watch, a payment terminal, an access control system, smart-jewellery, wireless earbuds or headphones, a gaming console, a medical device or a type of apparel.

It will be appreciated by a person skilled in the art that configuring the various components of the antenna arrangement to operate within certain frequency/time/impedance regimes may involve scaling the magnitudes of said components to suitable sizes, inductances, capacitances, resistances and other electrical characteristics to operate within the desired regime. It will be appreciated by a skilled person that just because components of another circuit may be connected in similar arrangements, if they are configured for operation of different technical uses, then they may not necessarily provide for the same technical effect as the circuits disclosed herein.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An antenna arrangement comprising:
a first antenna configured to receive and transmit a first set of near field communication signals;
a second antenna configured to receive and transmit a second set of near field communication signals wherein the first antenna is coupled in series with the second antenna;
a first transmitter path extending from a first end to a second end wherein the first antenna is arranged at the second end of the first transmitter path;
a second transmitter path extending from a first end to a second end wherein the second antenna is arranged at the second end of the second transmitter path;
a matching circuit comprising a first capacitor arranged in series between the first end of the first transmitter path and the first antenna, a second capacitor arranged in series between the first end of the second transmitter path and the second antenna;
a first receiver path coupled to the first transmitter path at a first tapping point wherein the first tapping point is between the first end of the first transmitter path and the first antenna; and
a second receiver path coupled to the second transmitter path at a second tapping point wherein the second tapping point is between the first end of the second transmitter path and the second antenna; and wherein
the antenna arrangement is absent an intermediate reference voltage node between the first antenna and the second antenna.

2. The antenna arrangement of claim 1 wherein the matching circuit further comprises a third capacitor coupled between the first capacitor and the second capacitor.

3. The antenna arrangement of any preceding claim further comprising:
a first EMC filter arranged between the first end of the first transmitter path and the first capacitor of the matching circuit; and
a second EMC filter arranged between the first end of the second transmitter path and the second capacitor of the matching circuit.

4. The antenna arrangement of claim 3 wherein the first tapping point is arranged between the first EMC filter and the first capacitor of the matching circuit and the second tapping point is arranged between the second EMC filter and the second capacitor of the matching circuit.

5. The antenna arrangement of any of claims 3-4, wherein each EMC filter is coupled to a reference voltage node.

6. The antenna arrangement of claim 5 wherein the first antenna and the second antenna are coupled to a reference voltage node via one or both of the first EMC filter and the second EMC filter.

7. The antenna arrangement of any of claims 5 - 6 wherein the first EMC filter comprises a capacitor having a first terminal coupled to the first tapping point, the second EMC filter comprises a capacitor arranged in series with the capacitor of the first EMC filter wherein the capacitor of the second EMC filter comprises a first terminal coupled to the second tapping point, and wherein the antenna arrangement further comprises a reference node configured to provide a reference voltage coupled between the capacitors of the first and second EMC filters.

8. A Near Field Communications, NFC, device comprising the antenna arrangement of any preceding claim.

## Amended claims

### Amended claims in accordance with Rule 137(2) EPC.

1. An antenna arrangement (100) comprising:
a first antenna (101) configured to receive and transmit a first set of near field communication signals;
a second antenna (102) configured to receive and transmit a second set of near field communication signals wherein the first antenna (101) is coupled in series with the second antenna (102);
a first transmitter path (103) extending from a first end to a second end wherein the first antenna (101) is arranged at the second end of the first transmitter path (103);
a second transmitter path (104) extending from a first end to a second end wherein the second antenna (102) is arranged at the second end of the second transmitter path (104);
a matching circuit (113) comprising a first capacitor (104) included in the first transmitter path (103) and being arranged in series between the first end of the first transmitter path (103) and the first antenna (101), a second capacitor (115) included in the second transmitter path (104) and being arranged in series between the first end of the second transmitter path (104) and the second antenna (102), and a third capacitor (116) coupled between the first capacitor (114) and the second capacitor (115);
a first receiver path (130) coupled to the first transmitter path (103) at a first tapping point (132) wherein the first tapping point (132) is between the first end of the first transmitter path (103) and the first antenna (101); and
a second receiver path (131) coupled to the second transmitter path (104) at a second tapping point (133) wherein the second tapping point (133) is between the first end of the second transmitter path (104) and the second antenna (102);
**characterized in that** the first capacitor (114) comprises a first capacitor divider including two capacitors arranged in series and the second capacitor (115) comprises a second capacitor divider including two capacitors arranged in series, wherein the first tapping point (132) is located between the two capacitors of the first capacitor divider, and wherein the second tapping point (133) is located between the two capacitors of the second capacitor divider.

2. The antenna arrangement (100) of claim 1 further comprising:
a first EMC filter (105) arranged between the first end of the first transmitter path (103) and the first capacitor (104) of the matching circuit (113); and
a second EMC filter (110) arranged between the first end of the second transmitter path (104) and the second capacitor (115) of the matching circuit (113).

3. The antenna arrangement (100) of -claim 2, wherein each EMC filter (105, 110) is coupled to a reference voltage node (108).

4. The antenna arrangement (100) of claim 5 wherein the first antenna (101) and the second antenna (102) are coupled to the reference voltage node (108) via one or both of the first EMC filter (105) and the second EMC filter (110).

5. A Near Field Communications, NFC, device (200) comprising the antenna arrangement (100) of any preceding claim.
